# EUROPEAN PATENT APPLICATION

(11) **EP 4 503 134 A1**
(43) Date of publication of application: **05.02.2025**
(21) Application number: 23188718.3
(22) Date of filing: 31.07.2023
(51) Int. Cl.: H01L 29/06, H01L 29/40, H01L 29/417, H01L 29/423, H01L 29/66, H01L 29/739, H01L 29/08, H01L 29/10, H01L 29/78

(54) **VERTICAL SEMICONDUCTOR DEVICE WITH A GATE ELECTRODE STRUCTURE HAVING LATERAL PROTRUSIONS AND METHOD FOR PRODUCING THE SEMICONDUCTOR DEVICE**

(71) Applicant: Hitachi Energy Ltd, 8050 Zürich (CH)
(72) Inventor: GUPTA, Gaurav, 5600 Lenzburg (CH); DE MICHIELIS, Luca, 5000 Aarau (CH)
(74) Representative: Epping - Hermann - Fischer

(57) **Abstract**

According to an embodiment, the semiconductor device (100) comprises a semiconductor body (1) having at least one source / emitter contact region (11) of a first conductivity type, a base region (12) of a second conductivity type and a drift region (14) of the first conductivity type. The semiconductor device further comprises a main electrode (2) and a gate electrode (3). The at least one contact region is embedded in the base region such that the contact region is separated from the drift region by the base region. The main electrode electrically contacts the at least one contact region. The base region has a main extension direction in a first lateral direction (L1). The gate electrode comprises at least two portions (30) which are spaced apart from each other in the first lateral direction. The at least two portions of the gate electrode overlap with areas of the base region when viewed in a direction (L2, V) perpendicular to the first lateral direction. Conductive portions 33 may be present between the gate portions (30).

## Description

The present disclosure relates to a semiconductor device and a method for producing a semiconductor device.

It is an object to provide a semiconductor device which contributes to improved switching characteristics, particularly without adversely affecting the static performance such as on-state losses. A further object is to provide a method for producing such a semiconductor device.

First, the semiconductor device is specified.

According to an embodiment, the semiconductor device comprises a semiconductor body having at least one contact region of a first conductivity type, a base region of a second conductivity type and a drift region of the first conductivity type. The semiconductor device further comprises a main electrode and a gate electrode. The at least one contact region is embedded in the base region such that the at least one contact region is separated from the drift region by the base region. The main electrode electrically contacts the at least one contact region. The base region has a main extension direction in a first lateral direction. The gate electrode comprises at least two portions which are spaced apart from each other in the first lateral direction. The at least two portions of the gate electrode overlap with areas of the base region when viewed in a direction perpendicular to the first lateral direction.

The present invention is, inter alia, based on the idea to provide a gate electrode which has portions spaced apart from each other in the first lateral direction, i.e. a split-gate concept is realized. This reduces parasitic capacitances (e.g. reduced Gate-Collector and Gate-Source overlap) and thus improves the switching characteristics. Particularly, gate charge and switching losses for the same Vce-sat are reduced. Moreover, lower gate-leakage due to reduced gate areal coverage is obtained.

Additionally, by providing a gate electrode with portions spaced apart from each other in the first lateral direction, the effective channel density can be reduced without splitting the contact region into several portions, which makes the mask for the contact region implementation redundant. This simplifies the production process and lowers its costs.

The semiconductor body comprises or consists of Si or SiC, for example. The semiconductor body may have a main extension plane. Lateral directions are directions parallel to the main extension plane. The semiconductor body has a top side and a bottom side opposite to the top side. The top side and the bottom side may, at least partially, run parallel to the main extension plane.

The contact region may adjoin the top side of the semiconductor body. In other words, the contact region may form a portion of the top side of the semiconductor body. The first contact region is of a first conductivity type, which may be n-type, i.e. it may be n-doped. The contact region is also called "source region". For example, the maximum and/or average doping concentration in the contact region is at least 10¹⁸ cm⁻³ or 10¹⁹ cm⁻³ or 10²⁰ cm⁻³.

The base region may adjoin the contact region. Particularly, the base region partially surrounds the contact region. The base region may separate the contact region from the drift region such that there is no direct contact between the contact region and the drift region. For example, the contact region only adjoins the base region and no other region of the semiconductor body. The base region is also called "well region" or "channel region". The base region may adjoin the top side, i.e. may form part of the top side of the semiconductor body.

The base region is of a second conductivity type which is opposite to the first conductivity type. The second conductivity type may be p-type, i.e. the base region may be p-doped. The maximum and/or average doping concentration in the base region is, for example, smaller than the minimum and/or average doping concentration in the contact region, e.g. by a factor of at least 10 or at least 100 or at least 1000.

The drift region is of the same conductivity type as the contact region. The maximum and/or average doping concentration of the drift region may be smaller than the maximum and/or average doping concentration of the contact region and/or of the base region, e.g. by a factor of at least 10 or at least 100 or at least 1000. The base region may adjoin the drift region.

The main electrode may be made of metal. For example, the main electrode is an emitter electrode or source electrode.

The main electrode, herein also called "first main electrode", may be arranged on the top side of the semiconductor body. The main electrode electricity contacts the contact region, e.g. adjoins the contact region, for example at the top side. Additionally or alternatively, the main electrode may contact/adjoin the contact region at a lateral side of the contact region. The main electrode may also contact/adjoin the base region, e.g. at the top side and/or at a lateral side of the base region.

A further main electrode, also called "second main electrode", may be arranged on the bottom side of the semiconductor body and may contact the semiconductor body at the bottom side. The further main electrode may be a collector electrode or drain electrode.

The main extension direction of the base region defines the first lateral direction. For example, the length of the base region is at least 2-times or at least 5-times or at least 10-times greater than the width and the thickness of the base region. Herein, lengths are defined as extensions in the first lateral direction. Widths are herein defined as extensions in a second lateral direction, which is perpendicular to the first lateral direction and, particularly, is also parallel to the main extension plane of the semiconductor body. Thicknesses are herein defined as extensions in a vertical direction perpendicular to the first and the second lateral direction, particularly perpendicular to the main extension plane of the semiconductor body.

The gate electrode may be made of metal and/or highly-doped polysilicon. The gate electrode comprises at least two portions which are spaced apart from each other in the first lateral direction. The two portions are, for example, electrically connected to each other via a main body of the gate electrode. The portions may each have a rectangular shape. For example, the distance between the two portions measured in the first lateral direction is at least 100 nm or at least 1 µm and/or at most 10 µm or at most 5 µm.

The at least two portions of the gate electrode are assigned to the base region and the at least one channel region. Particularly when viewed in the second lateral direction or the vertical direction, both portions of the gate electrode overlap with areas of the base region and, optionally, also with areas of the at least one contact region. The areas of the base region overlapped by the portions of the gate electrode extend, for example, from the contact region to the drift region. For example, the at least two portions of the gate electrode are close to the base region. For instance, a distance between the portions of the gate electrode and the base region is at most 1 µm or at most 300 nm. In particular, the at least two portion of the gate electrode are, at least partially, arranged on the same height in the vertical direction and/or in the second lateral direction.

"Viewed in a certain direction" means that the viewing direction is parallel to this certain direction.

The semiconductor device is, for example, configured such that, during operation, the at least two portions of the gate electrode establish or enable current paths between the at least one contact region and the drift region in the areas of the base region with which the portions of the gate electrode overlap. In other words, the two portions of the gate electrode are arranged and configured to establish or enable current paths between the at least one contact region and the drift region in those areas of the base region which overlap with the portions of the gate electrode when viewed in the second lateral direction and/or the vertical direction. For example, during operation, the portions of the gate electrode may deplete the overlapping areas of the base region or may inject charge carriers into the overlapping areas of the base region.

In other words, the areas of the base region overlapping with the gate electrode when viewed in the direction perpendicular to the first lateral direction are active areas of the base region through which, during normal operation, an electric current of, e.g., first-type charge carriers flows. The area of the base region which overlaps with the space between the portions of the gate electrode when viewed in the direction perpendicular to the first lateral direction is, for example, an inactive area. This area of the base region overlapping with the space between the portions of the gate electrode may be arranged between the drift region and the contact region when viewed in the direction perpendicular to the first lateral direction. Particularly, during normal operation no current, or a significantly lower current, is running through the inactive area as compared to the active areas. The inactive area may be at least half as big as each of the active areas. The inactive area comprises, for example, a part of the contact region and a part of the base region.

The gate electrode may comprise more than two portions with each two portions being spaced apart from each other in the first lateral direction. All features disclosed for the at least two portions are also disclosed for all other such portions of the gate electrode.

According to a further embodiment, the gate electrode is electrically insulated from the semiconductor body. Accordingly, the semiconductor device is a gate insulated semiconductor device. Particularly, the semiconductor device may be a transistor.

According to a further embodiment, the semiconductor device is configured such that, during operation, the at least two portions of the gate electrode deplete the areas of the base region with which they overlap when viewed in a direction perpendicular to the first lateral direction. In other words, the semiconductor device is configured to deplete the base region in the areas which overlap with the portions of the gate electrode.

According to a further embodiment, the semiconductor device is a trench device with the gate electrode being at least partially arranged in a trench of the semiconductor device. Particularly, the at least two portions of the gate electrode are arranged in the trench. In this case, the at least two portions of the gate electrode may overlap with the areas of the base region when viewed in the second lateral direction. The at least two areas of the base region which overlap with the portions of the gate region when viewed in the second lateral direction may then be arranged vertically between the at least one contact region and the drift region.

In the case of a gate insulated semiconductor device, an insulation layer is arranged in the trench. The insulation layer separates the gate electrode from the semiconductor body in the region of the trench.

According to a further embodiment, the trench extends vertically from the top side of the semiconductor body into the semiconductor body and opens into the semiconductor body. Particularly, the trench opens into the drift region of the semiconductor body.

According to a further embodiment, a main extension direction of the trench is in the first lateral direction. Particularly, a length of the trench is at least 2 times or at least 5 times or at least 10 times larger than a width of the trench and/or a depth of the trench, wherein the depth is measured in the vertical direction. The length of the trench may be essentially the same as the length of the base region, e.g. with a maximum deviation of 10 %. The trench may extend continuously and uninterrupted in the first lateral direction.

The at least two portions of the gate electrode may each extend essentially as deep into the semiconductor body as the trench. For example, the vertical extension of each of the portions of the gate electrode is at most 10% or at most 5% smaller than the depth of the trench. For example, each of the portions of the gate electrode is only separated from the bottom of the trench by the insulation layer.

In a cross-sectional view with the cutting plane extending parallel to the first lateral direction and parallel to the vertical direction and extending in the trench, the two portions of the gate electrode can either be completely separated from each other or the at least two portions are connected to each other by another section of the gate electrode. This connection by the other section may be located above the trench, i.e. outside the trench. In other words, when viewed in this cross-sectional view, the space between the two portions of the gate electrode may extend over the whole vertical direction or the space may be bridged over by a section of the gate electrode.

According to a further embodiment, the semiconductor device is a planar device with the gate electrode being arranged on the top side of the semiconductor body. In the case of a gate insulated semiconductor device, an insulating layer is arranged vertically between the gate electrode and the semiconductor body, for example.

According to at least one embodiment, the at least two portions of the gate electrode spaced apart from each other in the first lateral direction are arranged on the top side of the semiconductor body. Accordingly, the at least two portions of the gate electrode overlap with the areas of the base region when viewed in vertical direction, e.g. in top view of the top side. These areas of the base region, which overlap with the portions of the gate region when viewed in vertical direction, are arranged between the drift region and the at least one contact region in the second lateral direction.

According to at least one embodiment, the contact region is formed continuously without interruptions and extends, in the first lateral direction, essentially over the whole length of the base region. That is, the length of the contact region is essentially the same as the length of the base region. "Essentially" herein means with a deviation of at most 100, for example. Particularly, the contact region extends, in the first lateral direction, continuously without interruptions over the at least two portions of the gate electrode and also over the space between the at least two portions.

According to a further embodiment, the semiconductor body comprises at least two contact regions which are embedded in the base region such that the at least two contact regions are both separated from the drift region by the base region. For example, at least five or at least ten contact regions are embedded in the base region. The at least two contact regions may be at least partially arranged at the same height in the vertical and/or in the second lateral direction. All features disclosed herein for the at least one contact region embedded in the base region are also disclosed for all other contact regions embedded in the base region.

According to a further embodiment, the main electrode electrically contacts the at least two contact regions, e.g. adjoins them.

According to a further embodiment, the at least two contact regions are spaced apart from each other in the first lateral direction. In other words, the contact region is split in the first lateral direction. For example, a distance between each two contact regions measured in the first lateral direction is at least 100 nm or at least 1 µm and/or at most 10 µm or at most 5 µm.

According to a further embodiment, the space between the at least two contact regions and the space between the at least two portions of the gate electrode are at least partially arranged at the same height in the first lateral direction. In other words, when viewed in a direction perpendicular to the first lateral direction, e.g. the second lateral direction or the vertical direction, the space between the at least two contact regions and the space between the at least two portions of the gate electrode overlap partially or completely with each other. The lengths of the space between the at least two contact regions and the at least two portions of the gate electrode may essentially be the same, i.e. with a deviation of at most 100.

According to a further embodiment, the sum of the lengths of the at least two contact regions is at most 70% or at most 50% or at most 300 of the length of the base region in the first lateral direction. In other words, the sum of the lengths of the space(s) between the at least two contact regions is at least 300 or at least 50% or at least 70% of the length of the base region.

Having such a reduced extension of contact region(s) in the first lateral direction, i.e. having a reduced device effective channel density, helps to control short-circuit withstand time (inversely proportional to channel density), which is an important performance parameter for a power semiconductor device, for example.

Additionally or alternatively, the sum of the lengths of the at least two portions of the gate electrode is at most 70% or at most 50% or at most 300 of the length of the base region.

According to a further embodiment, the gate electrode has a finger structure with the at least two portions of the gate electrode forming fingers of the gate electrode. The fingers of the gate electrodes may be connected to each other by the main body of the gate electrode. In the case of a trench device, the fingers may extend in the vertical direction and in case of a planar device, the fingers may extend in the second lateral direction.

According to a further embodiment, the space between the at least two portions of the gate electrode is partially filled with an electrically conductive element. The electrically conductive element may fill the space to at least 50% or at least 80 %.

For example, in the case of a trench device, the electrically conductive element is arranged in the trench and is arranged, at least partially, at the same height in the second lateral direction as the at least two portions of the gate electrode. The electrically conductive element may then extend as deep into the trench as the at least two portions of the gate electrode.

In the case of a planar device, the electrically conductive element is arranged on the top side of the semiconductor body and, at least partially, at the same height in the vertical direction as the portions of the gate electrode.

According to a further embodiment, the electrically conductive element is electrically independent of the gate electrode. For example, the electrically conductive element is floating or is on the same electrical potential as the main electrode during operation of the semiconductor device. The electrically conductive element may be of the same material as the gate electrode, e.g. highly-doped polysilicon, or may be of the same material as the main electrode.

According to a further embodiment, the semiconductor body has two base regions, each with a main extension direction in the first lateral direction. The two base regions are spaced apart from each other in the second lateral direction. In fact, the semiconductor body may comprise more than two such base regions, wherein each two base regions are spaced apart from each other in the second lateral direction. All features disclosed herein for one base region are also disclosed for all other base regions. Particularly, in each of the base regions, at least one contact region is embedded such that the contact region is separated from the drift region by the respective base region.

According to a further embodiment, the gate electrode comprises at least two sections. The at least two sections may be electrically connected, i.e. lie on the same electrical potential during operation.

According to a further embodiment, the at least two sections are at least partially spaced apart from each other in the second lateral direction. For example, the at least two sections form a frame surrounding an opening/interruption in the gate electrode. This opening/interruption extends in the second lateral direction.

According to a further embodiment, each section has at least two portions which are spaced apart from each other in the first lateral direction. The portions of one section may be spaced apart from the portions of the other section in the second lateral direction. Each portion of one section may be assigned a portion of the other section such that the portions assigned to each other are, at least partially, arranged at the same height in the first lateral direction.

According to a further embodiment, each section of the gate electrode is assigned to a base region. Particularly, the portions of a section of the gate electrode overlap with the portions of the respectively assigned base region when viewed in a direction perpendicular to the first lateral direction, e.g. when viewed in the vertical direction.

According to a further embodiment, each of the sections has a finger structure with the fingers forming the portions of the gate electrode.

According to a further embodiment, the fingers of the at least two sections point in opposite directions, particularly opposite lateral directions. For example, the fingers of one section point in the second lateral direction and the fingers of the other section point in the direction opposite to the second lateral direction.

According to a further embodiment, the semiconductor device is a power semiconductor device. For example, the semiconductor device is configured for a maximum voltage between the main electrodes of at least 0.2 kV or of at least 0.6 kV or of at least 1.2 kV. Alternatively or additionally, the semiconductor device is configured for a current between the main electrodes of at least 0.01 kA or of at least 0.1 kA or of at least 1 kA and/or of at most 100 kA or of at most 10 kA. That is, a flow of current through the semiconductor device can be controlled by means of the gate electrode and by having the respective voltages between the main electrodes. , In particular this flow of current can be switched on and off by turning on and off a voltage at the gate electrode.

According to a further embodiment, the semiconductor device is an IGBT or a BIGT or a MOSFET or a MISFT or a thyristor.

Next, the method for producing a semiconductor device is specified. The method is, in particular, suited for producing a semiconductor device according to any of the embodiments described herein. Therefore, all features disclosed in connection with the semiconductor device are also disclosed for the method and vice versa.

According to an embodiment, the method for producing a semiconductor device comprises the step of providing a base semiconductor body having a drift region of a first conductivity type. A semiconductor body is then formed out of the base semiconductor body by forming at least one contact region of the first conductivity type and a base region of a second conductivity type. In the semiconductor body, the at least one contact region is embedded in the base region such that the contact region is separated from the drift region by the base region. The base region has a main extension direction in a first lateral direction. In a further step, a main electrode is formed. The main electrode electrically contacts the at least one contact region. In another step, a gate mask is applied onto the semiconductor body. Then, a gate electrode is formed with the help of the gate mask such that the gate electrode has at least two portions which are spaced apart from each other in the first lateral direction. The at least two portions overlap with areas of the base region when viewed in a direction perpendicular to the first lateral direction.

The step of applying the gate mask may be executed before or after forming the base region and/or the at least one contact region. Particularly, the gate electrode is formed by depositing a gate material over the gate mask. In the regions where the gate mask does not cover the semiconductor body, the gate electrode is formed out of the gate material and, in the regions which are covered by the gate mask, the deposited gate material is subsequently removed together with the gate mask so that these regions remain free of the gate electrode after removal of the mask.

According to at least one embodiment, the gate mask is used for forming the at least one contact region. For example, the at least one contact region is formed by ion implantation. The at least one contact region is formed in the regions where the gate mask does not cover the semiconductor body. No contact regions are formed in the regions which are covered by the gate mask.

According to a further embodiment, the at least one contact region extends, in the first lateral direction, over the at least two portions of the gate electrode and also over the space there between. For example, the contact region extends continuously without interruptions from one portion of the gate electrode, in the first lateral direction, to the next portion of the gate electrode. For example, the contact region extends continuously without interruptions essentially over the whole length of the base region.

Hereinafter, the semiconductor device and the method for producing a semiconductor device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. Insofar as elements or components correspond to one another in terms of their function in different figures, the description thereof is not repeated for each of the following figures. For the sake of clarity, elements might not appear with corresponding reference symbols in all figures.

Figures 1 to 16, 25 and 26 show different exemplary embodiments of the semiconductor device in different views,

Figure 17 to 24 show different positions in an exemplary embodiment of the method for producing a semiconductor device,

Figures 27 to 29 show a further exemplary embodiment of the semiconductor device in different vires.

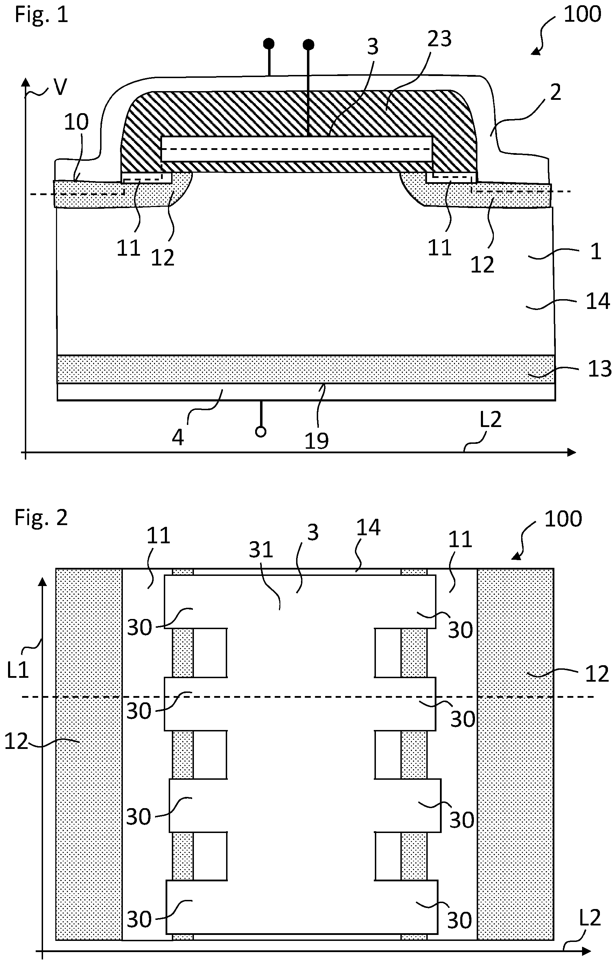

Figure 1 shows a first exemplary embodiment of the semiconductor device 100 in a cross-sectional view. Figure 2 shows the same semiconductor device in another cross sectional view (top view). The dashed line in figure 1 indicates the cut for the view of figure 2 and the dashed line in figure 2 indicates the cut for the view of figure 1.

The semiconductor device 100 is a power conductor device, particularly an IGBT. It comprises a semiconductor body 1, e.g. of Si or SiC. The semiconductor body 1 has a top side 10 and a bottom side 19 opposite to the top side 10. The direction from the bottom 19 to the top side 10 defines a vertical direction V. The semiconductor body 1 comprises a contact layer 13 adjoining the bottom side 19, a drift region 14 and two base regions 12 which are spaced apart from each other in a second lateral direction L2. Contact regions 11 are embedded in the base regions 12 such that the base regions 12 separate the contact regions 11 from the drift region 14. The contact regions 11 and the base regions 12 adjoin the top side 10 of the semiconductor body 1.

The contact regions 11 and the drift region 14 are of a first conductivity type which is, by way of example, n-type. The base regions 12 and the contact layer 13 are of a second conductivity type which, by way of example, is p-type.

A first main electrode 2 is applied onto the top side 10 and a second main electrode 4 is applied onto the bottom side 19 of the semiconductor body 1. The first main electrode 2 electrically contacts the contact regions 11 at lateral sides thereof. Moreover, the first main electrode 2 electrically contacts the base regions 12 in regions adjacent to the contact regions 12. The second main electrode 4 electrically contacts the contact layer 13.

The semiconductor device 100 of figure 1 is a planar device with a gate electrode 3 applied on the top side 10. The gate electrode 10 is arranged between the two base regions 12 in the second lateral direction L2. The gate electrode 3 is electrically insulated from the semiconductor body 1 and the first main electrode 2 by means of an insulation material 23.

As can be seen in figure 2, the base regions 12 and the contact regions 11 each have a main extension direction in a first lateral direction L1, which is perpendicular to the second lateral direction L2. It can be further seen in figure 2 that the gate electrode 3 comprises a main body 31. A plurality of portions 30 extend away from the main body 31 on two opposite sides of the main body. Particularly, the gate electrode 3 has two finger structures with the fingers forming the portions 30.

The portions 30 are spaced apart from each other in the first lateral direction L1. In the top view of figure 2, the portions 30 overlap with the base regions 12 and the contact regions 11. The base regions 12 and the contact regions 11 extend continuously without interruptions over the spaces between the portions 30.

During normal operation, the portions 30 of the gate electrode 3 deplete the areas of the base regions 12 with which they overlap so that current paths from the contact regions 11 through the depleted areas of base regions 12 into the drift region 14 are formed.

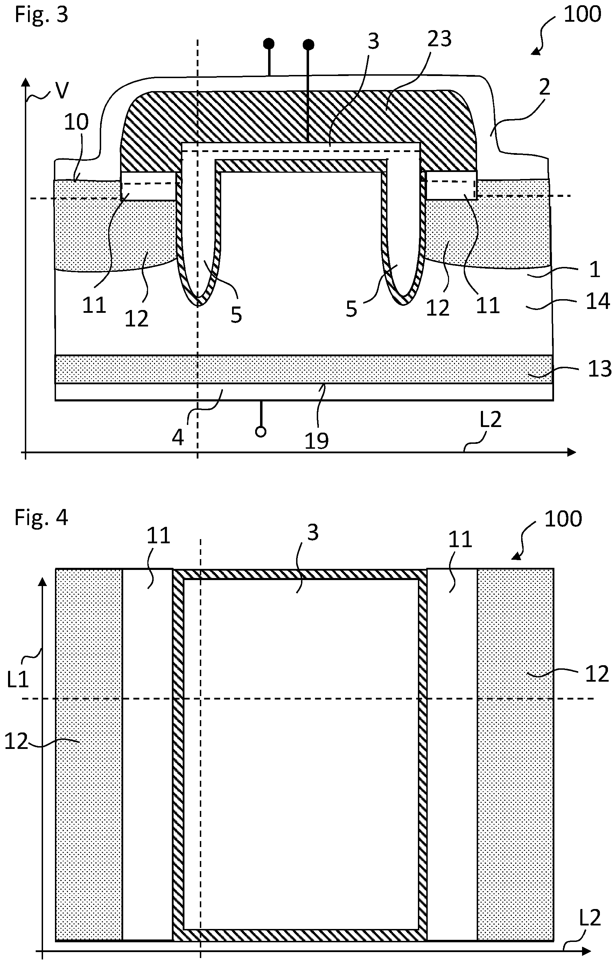

Figures 3 to 5 show a second exemplary embodiment of the semiconductor device 100, which is again realized as an IGBT. In contrast to the first exemplary embodiment, the semiconductor device is now a trench device with two trenches 5 extending from the top side 10 of the semiconductor body 1 into the semiconductor body 1 and opening into the drift region 14. The trenches 5 are filled with the gate electrode 3 which is electrically insulated from the semiconductor body 1 by means of the electrically insulating material 23.

Figure 4 is another cross-sectional view (top view) of the semiconductor device 100. The cut for this cross-sectional view is again indicated in figure 3 by the dashed-line running parallel to the direction L2.

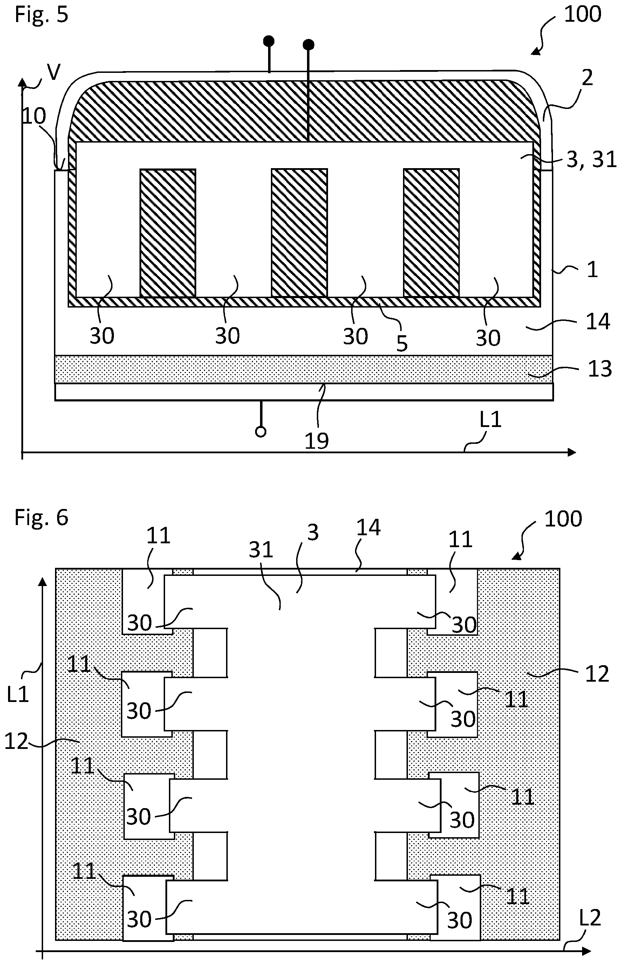

Figure 5 shows a cross-sectional view with the viewing direction in the second lateral direction L2. The cutting plane for figure 2 is illustrated by the vertical dashed lines in figures 3 and 4. Figure 5 again illustrates the different portions 30 of the gate electrode 3 which are spaced apart from each other in the first lateral direction L1. It can be seen that the portions 30 reach almost to the bottom of the trenches 5.

Figure 6 shows a further exemplary embodiment of the semiconductor device 100 again being a planar device. In contrast to the previous exemplary embodiments, a plurality of contact regions 11 is now embedded in each of the base regions 12, wherein in each base region 12 the contact regions 11 are spaced apart from each other in the first lateral direction L1. In the top view of figure 6, the portions 30 of the gate electrode 3 partially overlap with the contact regions 11. The spaces between the portions 30 and the spaces between the contact regions 11 are partially arranged at the same height in the first lateral direction L1.

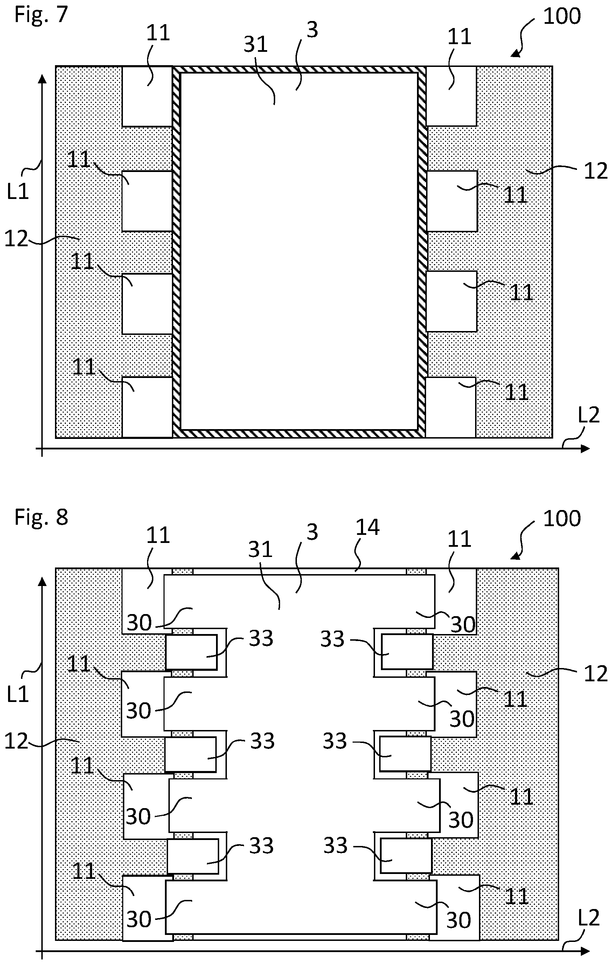

Figure 7 shows a further exemplary embodiment of the semiconductor device 100 being a trench device. Also here, a plurality of contact regions 11 being spaced apart from each other in the first lateral direction L1 is embedded in each of the base regions 12.

Figure 8 shows another exemplary embodiment of the semiconductor device 100, which is similar to that of figure 6. In contrast to figure 6, however, the spaces between the portions 30 of the gate electrode 3 are now each partially filled with an electrically conductive element 33. The electrically conductive elements 33 may be floating or may be on the same electrical potential as the first main electrode 2.

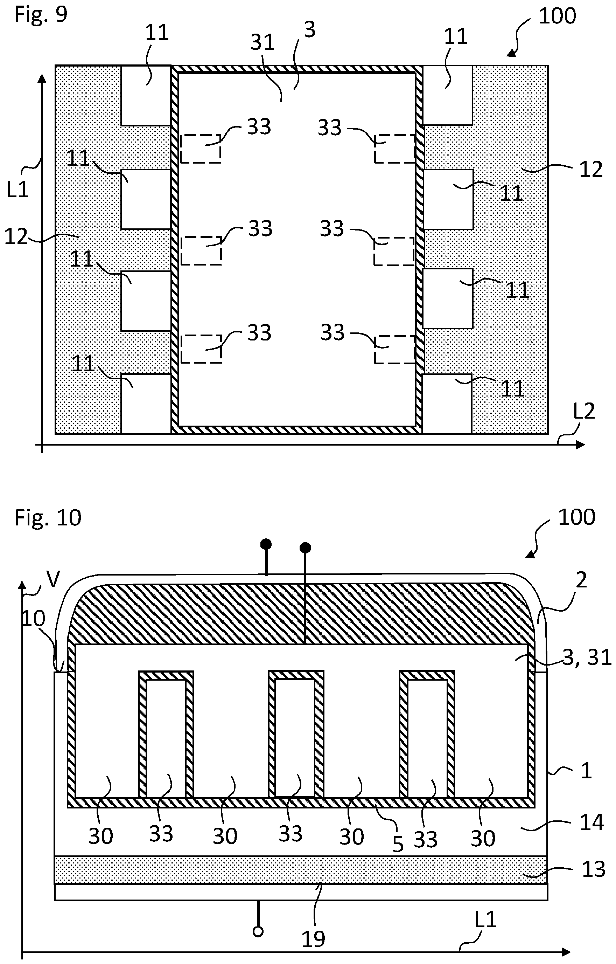

Figure 9 shows an exemplary embodiment of the semiconductor device 100 which is similar to that of figure 7. It also comprises the electrically conductive elements 33 in the spaces between the portions 30 of the gate electrode 3. Since the elements 33 are actually covered by the gate electrode 3 or its main body 31, respectively, they are indicated by the dashed rectangles in the cross-sectional view of figure 9,. Also these electrically conductive elements 33 may be floating or may be on the same electrical potential as the first main electrode 2.

Figure 10 shows the exemplary embodiment of figure 9 in a cross-sectional view when viewed along the second lateral direction L2. Here it can be seen that the electrically conductive elements 33 fill the spaces between the portions 30 and reach into the trenches 5 as deep as the portions 30.

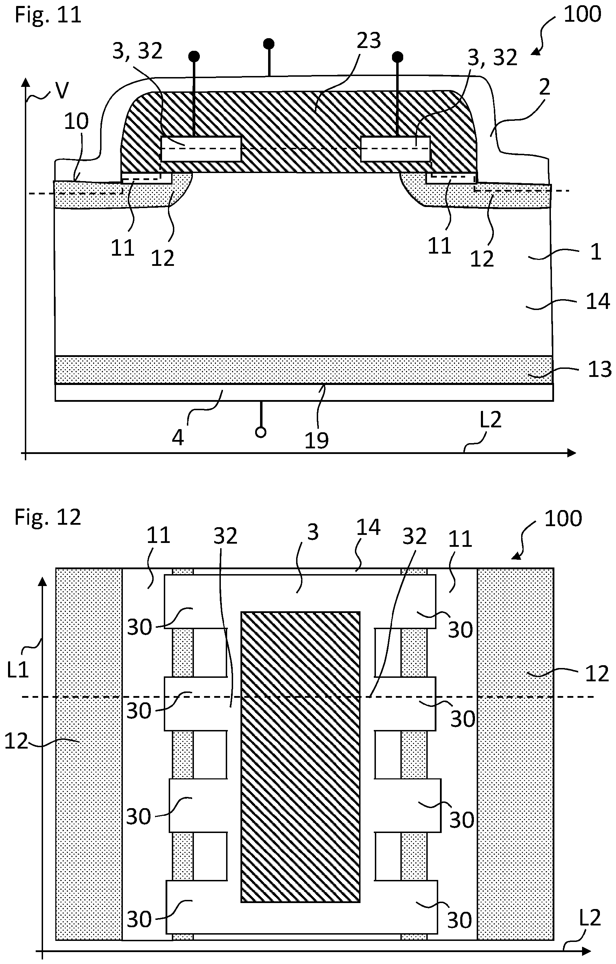

In the exemplary embodiment of the semiconductor device 100 of figures 11 and 12, the semiconductor device 100 is of planar construction. The gate electrode 3 comprises two sections 32 which are partially spaced apart from each other in the second lateral direction L2. As can be seen in the top view of figure 12, the two sections 32 actually form a frame surrounding an opening in the gate electrode 3. The space/opening surrounded by the two sections 32 overlaps with an area of the semiconductor body 1, this area is arranged between the two base regions 12 in the second lateral direction L2.

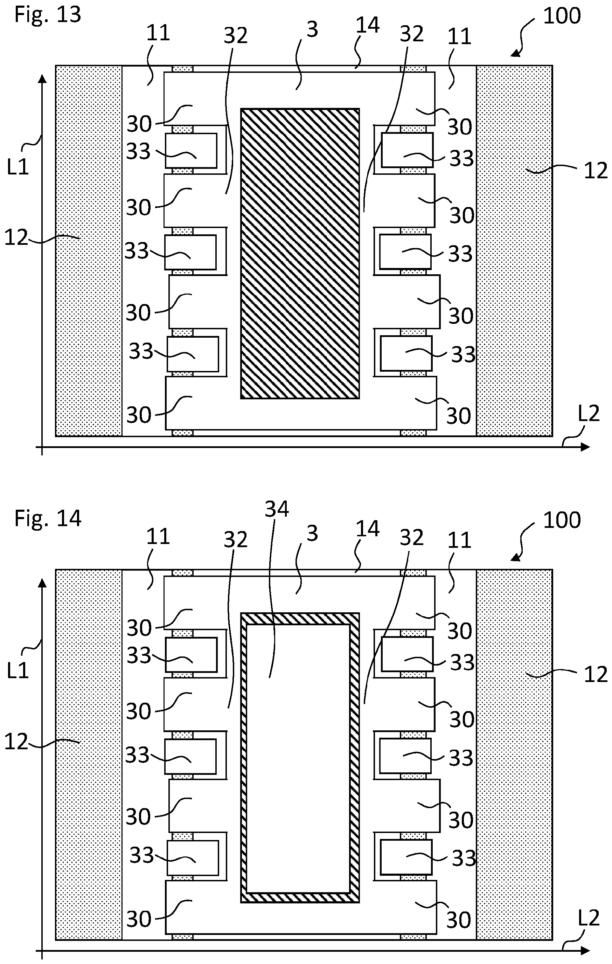

Figure 13 shows another exemplary embodiment of the semiconductor device 100 in top view. It is similar to that of figures 11 and 12, but now has electrically conductive elements 33 arranged in the spaces between the portions 30 of the gate electrode 3.

Figure 14 shows an exemplary embodiment of the semiconductor device 100 which is based on the exemplary embodiment of figure 13. The opening or space surrounded by the two sections 32 is now also filled with an electrically conductive element 34. This electrically conductive element 34 may be floating or may be on the same electrical potential as the first main electrode 2.

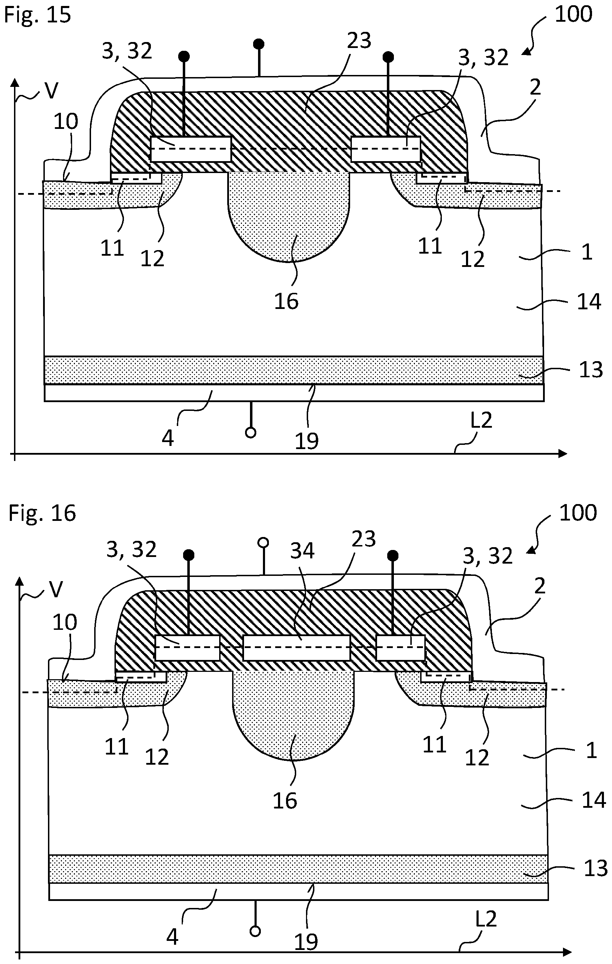

Figure 15 shows an exemplary embodiment of the semiconductor device 100 which is based on the exemplary embodiment of figure 11, but now has a deep well 16 arranged in the region between the two sections 32 in the second lateral direction L2. This deep well 16 is of the second conductivity type and reaches deeper into the semiconductor body 1 than the base regions 12. Such a deep well 16 can help to improve the on-state resistance. The deep well 16 may be electrically contacted by the first main electrode 2.

Figure 16 shows an exemplary embodiment of the semiconductor device 100 which is based on that of figure 14, i.e. with an electrically conductive element 34 in the opening of the gate electrode 3, and which additionally comprises the deep well 16.

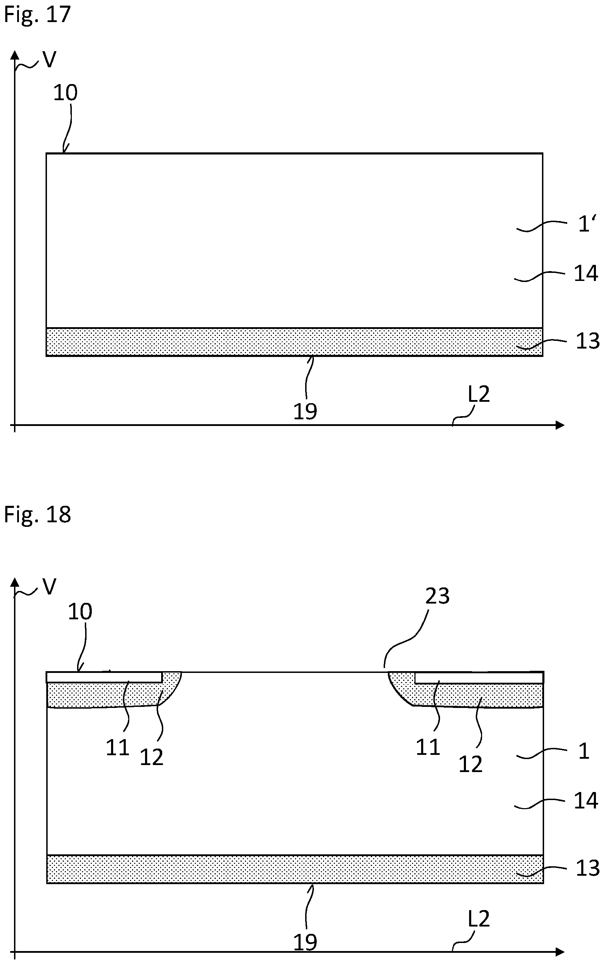

Figure 17 shows a position in an exemplary embodiment of the method for producing a semiconductor device. A base semiconductor body 1' is provided which comprises a drift region 14 and a contact layer 13.

Figure 18 shows a later position, in which a semiconductor body 1 has been formed out of the base semiconductor body 1' by forming base regions 12 and contact regions 11. The regions 11, 12 may have been formed with the help of ion implantation.

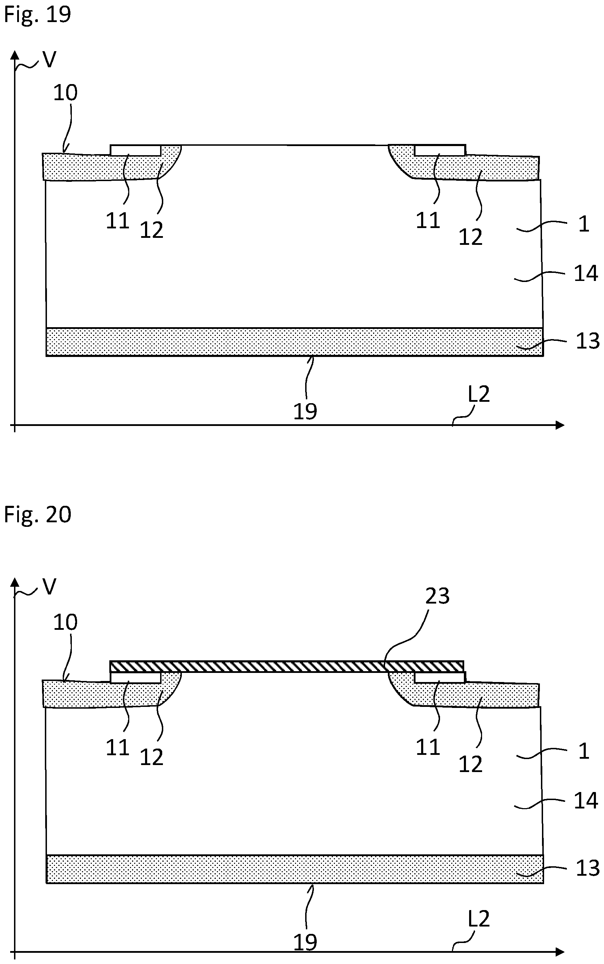

In the position of figure 19, portions of the semiconductor body 1 have been removed so that lateral sides of the contact regions 11 have been exposed.

In the position of figure 20, a layer of electrically insulating material 23 has been applied onto the top side 10. The layer of the electrically insulating material 23 may be deposited with the help of a mask, which is not shown. Areas of the contact regions 11 and the base regions 12 at the top side 10 of the semiconductor body 1 remain free of the layer of the electrically insulating material 23.

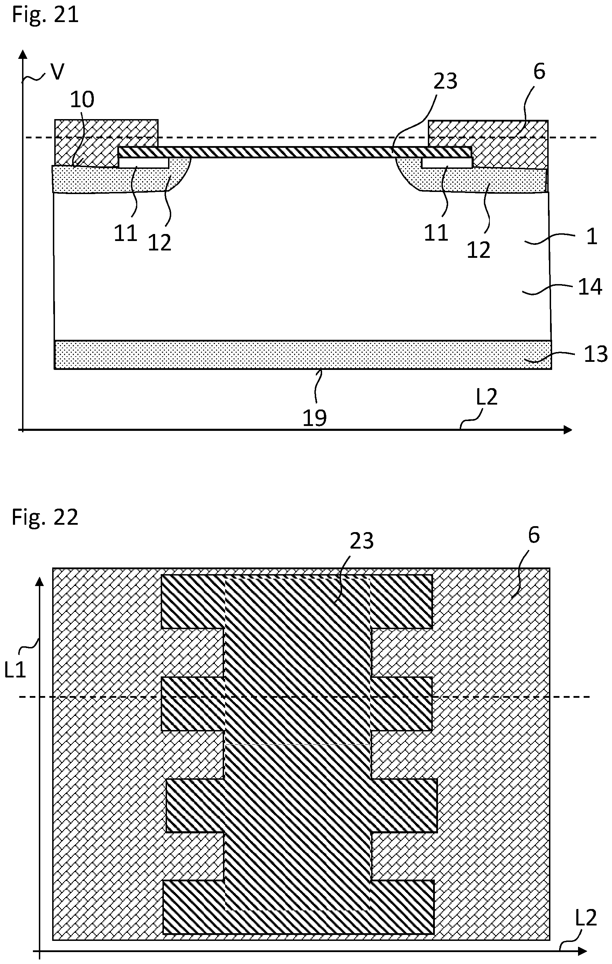

Figures 21 and 22 show a position in which a gate mask 6 is applied onto the top side 10 of the semiconductor body 1. Figure 19 shows a cross-sectional view and figure 20 shows a top view.

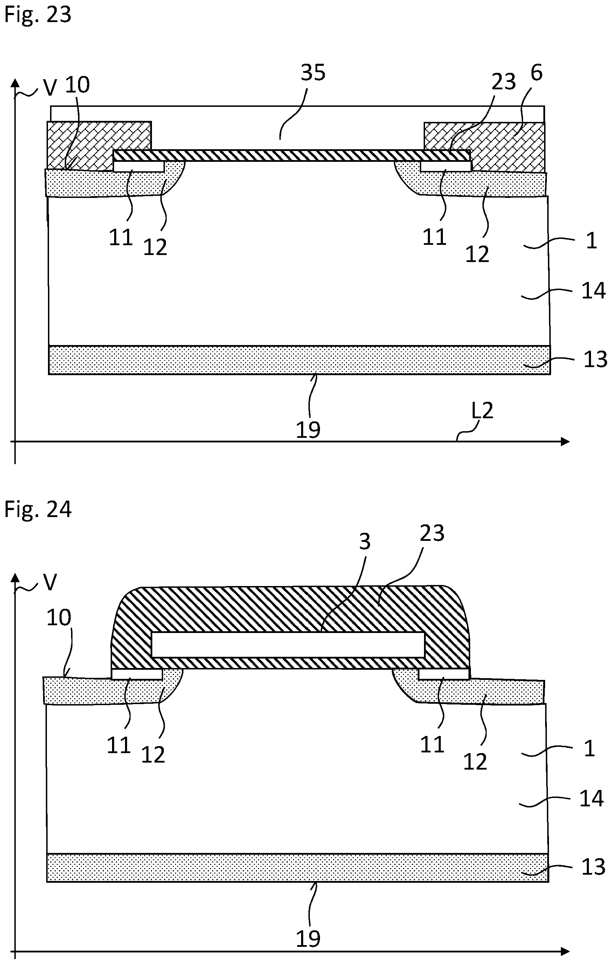

In the position of figure 23, a gate material 35 is applied onto the gate mask 6.

Figure 24 shows a position after removal of the gate mask 6 and the gate material 35 which has been deposited thereon.

The remaining gate material forms a gate electrode 3. Furthermore, in figure 24, the gate electrode 3 is covered by electrically insulating material 23.

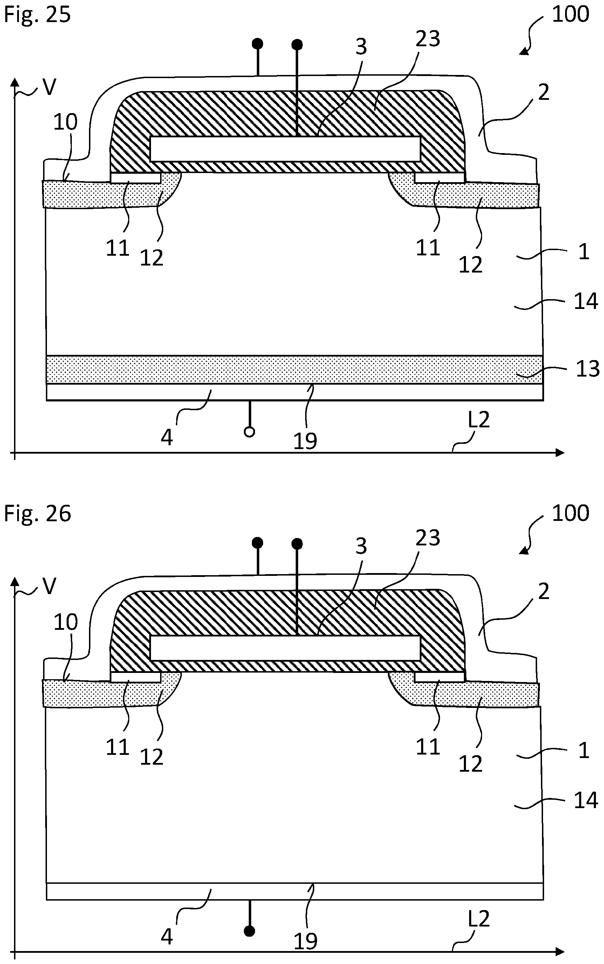

In the position of figure 25, main electrodes 2 and 4 have been deposited onto the top side 10 and the bottom side 19 of the semiconductor body 1. The second main electrode 4 thereby electrically contacts the contact layer 13 and the first main electrode 2 electrically contacts the contact regions 11 at their previously exposed lateral sides. At the same time Figure 25 shows a finalized semiconductor device 100.

In the previous exemplary embodiments, the semiconductor device 100 has always been realized as an IGBT. In the exemplary embodiment of figure 26, a semiconductor device 100 is in the form of a MISFET or MOSFET, respectively. The main electrode 4 directly contacts the drift region 14 in this example.

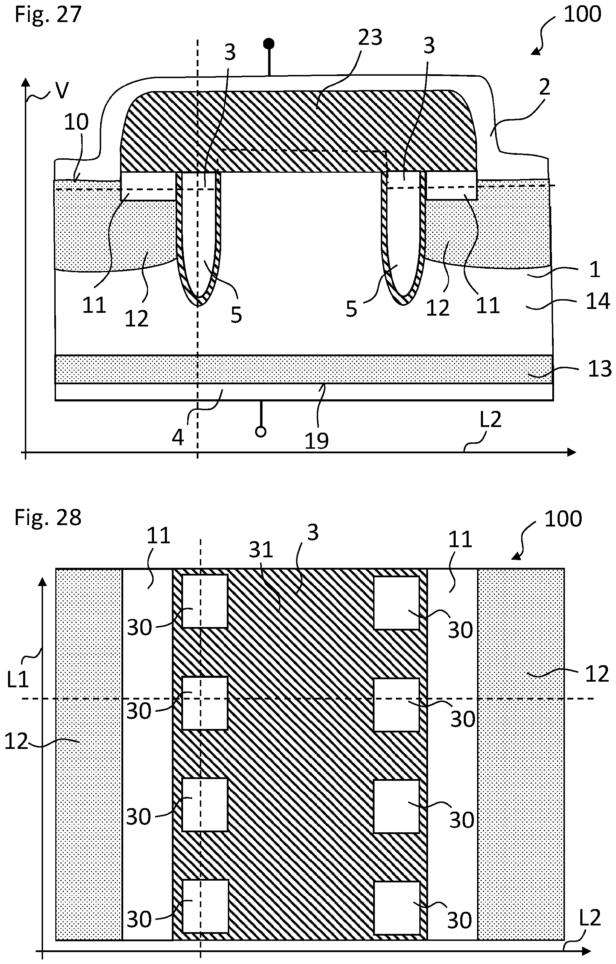

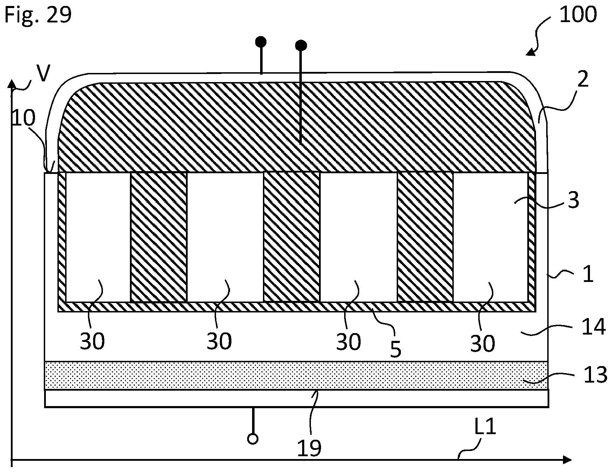

Figures 27 to 29 show an exemplary embodiment of the semiconductor device 100 being a trench device. Essentially the same views as in figures 3 to 5 are shown. However, the different portions 30 of the gate electrode 3 are now not bridged over by a section of the gate electrode. Rather, the different portions 30 are all separated from each other.

The embodiments shown in the Figures 1 to 26 as stated represent exemplary embodiments of the semiconductor device and the method for producing a semiconductor device; therefore, they do not constitute a complete list of all embodiments according to the semiconductor device and the method. Actual semiconductor devices and methods may vary from the embodiments shown in terms of arrangements, elements and regions, for example.

### Reference Signs

- 1: semiconductor body
- 1': base semiconductor body
- 2: first main electrode
- 3: gate electrode
- 4: second main electrodes
- 5: trench
- 6: gate mask
- 10: top side
- 11: contact region
- 12: base region
- 13: contact layer
- 14: drift region
- 16: deep well
- 19: bottom side
- 23: electrically insulating material
- 30: portion of the gate electrode
- 31: main body of the gate electrode
- 32: section of the gate electrode
- 33: electrically conductive element
- 34: electrically conductive element
- 35: gate material
- 100: semiconductor device
- L1: first lateral direction
- L2: second lateral direction
- V: vertical direction

## Claims

1. Semiconductor device (100) comprising
- a semiconductor body (1) having at least one contact region (11) of a first conductivity type, a base region (12) of a second conductivity type and a drift region (14) of the first conductivity type,
- a main electrode (2) and a gate electrode (3), wherein
- the at least one contact region (11) is embedded in the base region (12) such that the at least one contact region (11) is separated from the drift region (14) by the base region (12),
- the main electrode (2) electrically contacts the at least one contact region (11),
- the base region (12) has a main extension direction in a first lateral direction (L1),
- the gate electrode (3) comprises at least two portions (30) which are spaced apart from each other in the first lateral direction (L1),
- the at least two portions (30) of the gate electrode (3) overlap with areas of the base region (12) when viewed in a direction (L2, V) perpendicular to the first lateral direction (L1).

2. Semiconductor device (100) according to claim 1, wherein
- the gate electrode (3) is electrically insulated from the semiconductor body (2) and
- the semiconductor device (100) is configured such that, during operation,
- the at least two portions (30) of the gate electrode (3) deplete the areas of the base region (12) with which they overlap.

3. Semiconductor device (100) according to claim 1 or 2, wherein
- the semiconductor device (100) is a trench device with the at least two portions (30) of the gate electrode (3) being arranged in a trench (5),
- the trench (5) extends from the top side (10) of the semiconductor body (1) vertically into the semiconductor body (1) and opens into the semiconductor body (1),
- a main extension direction of the trench (5) is in the first lateral direction (L1).

4. Semiconductor device (100) according to claim 1 or 2, wherein
- the semiconductor device (100) is a planar device with the gate electrode (3) being arranged on a top side (10) of the semiconductor body (1),
- in top view of the top side (10) the at least two portions (30) of the gate electrode (3) overlap with areas of the base region (12) which are arranged, in a second lateral direction (L2), between the drift region (14) and the contact region (11), said second lateral direction (L2) being perpendicular to the first lateral direction (L1).

5. Semiconductor device (100) according to any one of the preceding claims, wherein
- the contact region (11) is formed continuously without interruptions and extends, in the first lateral direction (L1), essentially over the whole length of the base region (12) .

6. Semiconductor device (100) according to any one of claims 1 to 4, wherein
- the semiconductor body (1) comprises at least two contact regions (11) which are embedded in the base region (12) such that the contact regions (11) are separated from the drift region (14) by the base region (12),
- the main electrode (2) electrically contacts the at least two contact regions (11),
- the at least two contact regions (11) are spaced apart from each other in the first lateral direction (L1),
- the space between the at least two contact regions (11) and the space between the at least two portions (30) of the gate electrode (3) are at least partially arranged at the same height in the first lateral direction (L1).

7. Semiconductor device (100) according to claim 6, wherein
- the sum of the lengths of the at least two contact regions (11) in the first lateral direction (L1) is at most 70% of the length of the base region (12) in the first lateral direction (L1).

8. Semiconductor device (100) according to any one of the preceding claims, wherein
- the gate electrode (3) has a finger structure with the at least two portions (30) of the gate electrode (3) forming fingers of the gate electrode (3).

9. Semiconductor device (100) according to any one of the preceding claims, wherein
- the space between the at least two portions (30) of the gate electrode (3) is partially filled with an electrically conductive element (33),
- the electrically conductive element (33) is floating or is on the same electrical potential as the main electrode (2) during operation of the semiconductor device (100).

10. Semiconductor device (100) according to any one of the preceding claims, wherein
- the semiconductor body (1) has two base regions (12), each with a main extension direction in the first lateral direction (L1), wherein
- the two base regions (12) are spaced apart from each other in a second lateral direction (L2) which is perpendicular to the first lateral direction (L1),
- in each of the base regions (12) at least one contact region (11) is embedded such that the contact region (11) is separated from the drift region (14) by the respective base region (12),
- the gate electrode (3) comprises at least two sections (32) which are at least partially spaced apart from each other in the second lateral direction (L2),
- each section (32) has at least two portions (30) which are spaced apart from each other in the first lateral direction (L1),
- each section (32) of the gate electrode (3) is assigned to a base region (12) such that the portions (30) of the sections (32) overlap with areas of the respectively assigned base region (12) when viewed in a direction (L2, V) perpendicular to the first lateral direction (L1).

11. Semiconductor device (100) according to claim 10 and claim 8, wherein
- each of the sections (32) has a finger structure with the fingers forming the portions (30) of the gate electrode (3),
- the fingers of the at least two sections (32) point in opposite directions.

12. Semiconductor device (100) according to any one of the preceding claims, wherein
- the semiconductor device (100) is a power semiconductor device (100).

13. Semiconductor device (100) according to any one of the preceding claims, wherein
- the semiconductor device (100) is an IGBT or a BIGT or a MOSFET or a MISFET or a thyristor.

14. Method for producing a semiconductor device (100) comprising the steps of
- providing a base semiconductor body (1') with a drift region (14) of a first conductivity type,
- producing a semiconductor body (1) out of the base semiconductor body (1') by forming at least one contact region (11) of the first conductivity type and a base region (12) of a second conductivity, wherein, in the semiconductor body (1)
- the at least one contact region (11) is embedded in the base region (12) such that the contact region (11) is separated from the drift region (14) by the base region (12),
- the base region (12) has a main extension direction in a first lateral direction (L1),
- forming a main electrode (2) which electrically contacts the at least one contact region (11),
- applying a gate mask (6) onto a top side (10) of the semiconductor body (1),
- forming a gate electrode (3) with the help of the gate mask (6) such that
- the gate electrode (3) has at least two portions (30) which are spaced apart from each other in the first lateral direction (L1),
- the at least two portions (30) overlap with areas of the base region (12) when viewed in a direction (L2, V) perpendicular to the first lateral direction (L1).

15. Method according to claim 14, wherein
- the at least one contact region (11) extends, in the first lateral direction (L1), over the at least two portions (30) of the gate electrode (3) and the space there between.
